Europäisches Patentamt

European Patent Office

Office européen des brevets

(19)

(11) Veröffentlichungsnummer: **0 147 518**
**B1**

(12) # EUROPÄISCHE PATENTSCHRIFT

(45) Veröffentlichungstag der Patentschrift: 03.10.90

(51) Int. Cl.⁵: **H 03 J 3/32**

(21) Anmeldenummer: **84108854.5**

(22) Anmeldetag: **26.07.84**

(54) Verfahren zum Abgleich eines mehrstufigen selektiven Verstärkers und Anordnung zur Durchführung des Verfahrens.

(30) Priorität: **07.09.83 DE 3332206**

(43) Veröffentlichungstag der Anmeldung:
**10.07.85 Patentblatt 85/28**

(45) Bekanntmachung des Hinweises auf die
Patenterteilung:
**03.10.90 Patentblatt 90/40**

(84) Benannte Vertragsstaaten:
**DE FR GB IT**

(56) Entgegenhaltungen:
**EP-A-0 044 237**
**DE-A-2 854 852**
**US-A-4 334 323**

(73) Patentinhaber: **GRUNDIG E.M.V. Elektro-Mechanische Versuchsanstalt Max Grundig holländ. Stiftung & Co. KG.**
**Kurgartenstrasse 37**
**D-8510 Fürth/Bay. (DE)**

(72) Erfinder: **Heucke-Gareis, Wilhelm**
**Einsteinstrasse 11**
**D-6806 Viernheim (DE)**
Erfinder: **Oertel, Eberhard**
**Köhnstrasse 56**
**D-8500 Nürnberg (DE)**

(74) Vertreter: **Kolb, Max**
**Kurgartenstrasse 37**
**D-8510 Fuerth/Bayern (DE)**

Courier Press, Leamington Spa, England.

## Beschreibung

Die Erfindung betrifft ein Verfahren zum Abgleich eines mit mehreren unabhängig voneinander ansteuerbaren Reaktanzelementen abstimmbaren mehrstufigen selektiven Verstärkers, insbesondere Tuners. Ferner betrifft die Erfindung eine Anordnung zur Durchführung eines solchen Verfahrens.

Aus der EP—A—0 044 237 ist die Abstimmung eines elektronischen Schaltkreises, insbesondere eines Fernsehempfängers, mit mehreren variablen Elementen bekannt. Dieses Dokument erwähnt insbesondere die Abstimmung eines Filters oder eines Oszillators mit Kapazitätsdioden. Die bekannte Abgleichvorrichtung enthält einen bereits zum Zeitpunkt der Herstellung festprogrammierten Speicher (PROM), der als Funktion der Kennlinien der variablen Elemente programmiert wird, um beispielsweise Eingriffe des Benutzers zu vermeiden. Die abgespeicherten Informationen dienen für die Erzeugung der Steuersignale für die elektronischen Mittel zur Abstimmung. Hierzu werden Abgleichwerte an die Abgleichvorrichtung angelegt und die einzelnen Abgleichgrößen ausgelesen. Im bekannten Falle geht es im wesentlichen darum, daß im festprogrammierten Speicher Platz gespart wird, was durch eine Abspeicherung der einzelnen Differenzen der Abgleichgrößen zueinander erfolgt.

Bei bekannten elektronisch abstimmbaren selektiven Verstärkern, insbesondere Tunern, werden in den Vor-, Drain-, Misch- und Oszillatorkreisen meist spannungsgesteuerte variable Reaktanzelemente (Kapazitätsdioden) zur Abstimmung verwendet. Dort werden den für die Abstimmung verwendeten Kapazitätsdioden getrennte und voneinander unabhängig veränderbare Abstimmspannungen zugeführt. Jeweils nach Wahl eines neuen Frequenzkanals wird der Tuner von einem Mikroprozessor mit Hilfe der unabhängig veränderbaren Abstimmspannungen automatisch abgeglichen. Hierzu trennt zunächst der Mikroprozessor die Antenne vom Eingang des Vorkreises und koppelt anstelle des Antennensignals das Ausgangssignal des von einer PLL gesteuerten Oszillators in den Vorkreis ein. Dabei entspricht die Frequenz dieses Signals der vorher gewählten Kanalfrequenz. Der Abgleich der einzelnen Kreise erfolgt nacheinander durch Variation der dem jeweiligen Abstimmelement zugeführten Abstimmspannung. Ein am Ausgang des letzten Kreises angeschlossener Detektor kontrolliert den Pegel der Signaldurchlaßkurve und veranlaßt die Beendigung des jeweiligen Abgleichschrittes, sobald ein Maximum der Signaldurchlaßkurve auftritt. Nach Beendigung des gesamten Abgleichvorganges trennt der Mikroprozessor den Oszillator wieder vom Eingang des Vorkreises und schaltet die Antenne an den betreffenden Eingang an. Die vorher ermittelten Abstimmspannungen werden in einem Kurzzeitspeicher digital abgelegt und bei der Wahl eines anderen Kanals wieder gelöscht (US—A—43 34 323).

Die Nachteile dieses Tuners liegen zum einen in der relativ aufwendigen Abgleicheinheit, die zudem gesondert in den Tuner bzw. jedes Rundfunk- oder Fernsehgerät eingebaut werden muß und damit höhere Gerätekosten verursacht. Zum anderen muß sich der Tuner jeweils nach der Wahl eines anderen Kanals wieder neu abgleichen, da die Abstimmdaten für die einzelnen Kanäle nicht abrufbereit gespeichert werden. Im übrigen wäre eine Speicherung der Abstimmdaten mit einem hohen kostenmäßigen und technischen Aufwand an Speicherkapazität verbunden, falls für jeden wählbaren Frequenzkanal mehrere Abstimmspannungen abgespeichert werden sollen.

Der Erfindung liegt die Aufgabe zugrunde, ein Verfahren der im Oberbegriff des Anspruchs 1 angegebenen Art und eine Anordnung gemäß Oberbegriff des Anspruchs 7 zur Durchführung des Verfahrens so auszubilden, daß die genannten kostenmäßigen und technischen Nachteile entfallen.

Diese Aufgabe wird gemäß der Erfindung durch die im Anspruch 1 angegebenen Maßnahmen bzw. durch die im Anspruch 7 enthaltenen Merkmale gelöst. Vorteilhafte Weiterbildungen der Erfindung sind in den Unteransprüchen gekennzeichnet.

Bei dem erfindungsgemäßen Verfahren zum Abgleich eines selektiven Verstärkers, insbesondere eines Tuners, werden zwar die Abstimmdioden der Vor-, Drain-, Misch- und Oszillatorkreise in bekannter Weise von getrennt veränderbaren Abstimmspannungen angesteuert. Jedoch erfolgt der Abgleich des selektiven Verstärkers im Gegensatz zu den bekannten Verfahren über eine extern an den Verstärker anschließbare wahlweise automatische oder manuell betätigbare Abgleichvorrichtung. Diese Abgleichvorrichtung enthält im Unterschied zu dem Bekannten einen Zwischenspeicher zur Zwischenspeicherung der in iterativen Abgleichschritten gewonnenen Abgleichwerte für die einzelnen Reaktanzelemente, während der selektive Verstärker selbst mit einem nichtflüchtigen Speicher ausgestattet ist, in den die Abgleichvorrichtung nach beendetem Abgleich die optimierten Abgleichwerte überträgt. Diese Abgleichwerte sind dann für den späteren Betriebszustand des Verstärkers permanent gespeichert.

In vorteilhafter Weise werden die für den optimalen Abgleich der Frequenzkanäle ermittelten Abstimmspannungen für die einzelnen Kapazitätsdioden in einem nicht flüchtigen, internen Speicher des Tuners digital abgespeichert. Zur Einsparung von Speicherplätzen wird der Tuner nur in jedem n-ten Frequenzkanal abgeglichen, für den jeweils auch die entsprechenden Abstimmspannungen in digitalisierter Form permanent im Speicher des Tuners abgelegt werden. Je nachdem, in welchem Teil der Diodenkennlinien (Spannungs-Kapazitäts-Kennlinien) sich die Abstimmspannungen für die verschiedenen Frequenzkanäle bewegen, variiert n in einem Bereich $n \geq 2$. Dabei werden bevorzugt die Kanäle, für die die Abstimmspannungen in den Bereich der Kennlinienknicke fallen, in einer dichteren Reihenfolge abgespeichert ($2 \leq n \leq 3$) als die Kanäle, deren Abstimmspannungen im linearen und flachen Teil der Kennlinien liegen ($n > 3$). Ferner werden die Abstimmspannungen für den Vor-, Drain- und Mischkreis nicht in ihrer absoluten Größe digital abgespeichert, sondern es werden lediglich deren Differenzwerte zu der Oszillatorabstimmspannung im nicht flüchtigen Speicher des Tuners abgelegt.

Durch diese Maßnahmen ist es möglich, die benötigte Speicherkapazität so weit zu reduzieren, daß beim Einbau des Tuners in einen Fernsehempfänger die dort noch frei zur Verfügung stehende Speicherkapazität eines ohnehin vorhandenen Speichers ausreichend ist. Beim Einsatz des Tuners in einen Fernsehempfänger wird über den dort ebenfalls schon vorhandenen Mikrocomputer auf die fest abgespeicherten Abstimmdaten zugegriffen. Die Abstimmdaten der nicht abgespeicherten Frequenzkanäle (Bereich $n > 2$) ermittelt der Mikrocomputer durch lineare Interpolation aus den diesen Kanälen benachbarten permanent abgespeicherten Abstimmdaten. Die bei dieser Näherung entstehenden Abgleichfehler sind vernachlässigbar klein.

Ein Ausführungsbeispiel der Erfindung ist im folgenden anhand einer Zeichnung näher erläutert.

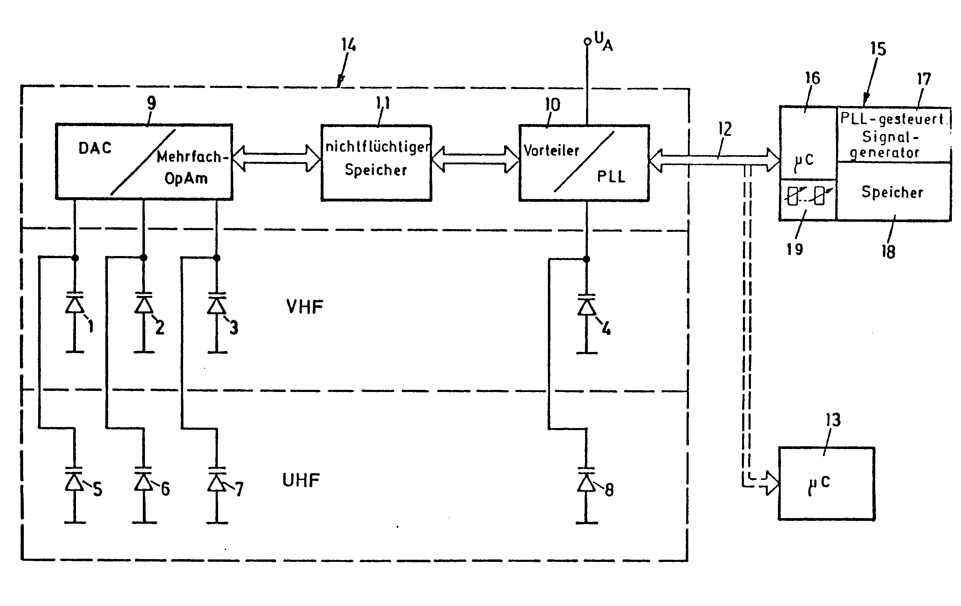

Die Figur zeigt ein vereinfachtes Blockschaltbild eines abzugleichenden VHF/UHF-Tuners für einen Fernsehempfänger.

Hierbei sind die Vor-, Drain-, Misch- und Oszillatorkreise des VHF- und UHF-Teiles symbolisch durch die Kapazitätsdioden 1 bis 4 und 5 bis 8 dargestellt. Ein mit einem Digital-Analog-Converter 9 gekoppelter Mehrfach-Operationsverstärker steht über separate Steuerleitungen mit den Kapazitätsdioden 1 und 5, 2 und 6 sowie 3 und 7 der Vor-, Drain- und Mischkreise in Verbindung. Die Kapazitätsdioden 4 und 8 der Oszillatorkreise sind an eine Phasenregelschleife (Phase-Locked Loop, PLL) 10 mit vorgeschaltetem Frequenz-Vorteiler angeschlossen. Ferner sind der Digital-Analog-Converter 9 und die Phasenregelschleife 10 jeweils über einen Datenbus ($I^2C$-Bus) mit einem nichtflüchtigen Speicher 11 verbunden. Ein weiterer von der PLL 10 abgehender Datenbus 12 bildet den Steuereingang und/oder -ausgang des Tuners. Ferner liegt an dem aus Frequenz-Vorteiler und PLL kombinierten Baustein 10 die maximal zur Verfügung stehende Abstimmspannung $U_A$.

Eine derartige Anordnung wird zu ihrem einmaligen Abgleich an eine Abgleichvorrichtung 15 angeschlossen. Für den Fall des automatischen Abgleichs schaltet diese nacheinander über einen Mikrocomputer 16 selbsttätig die abzugleichenden Kanäle durch und führt jeweils den Abgleich aus. Hierbei rastet die Phasenregelschleife 10 auf die jeweilige Kanalfrequenz ein und steuert die Oszillatorabstimmspannung so, daß der Oszillator ebenfalls auf der betreffenden Kanalfrequenz arbeitet. Diese Oszillatorabstimmspannung bildet dann den Ausgangspunkt für den Abgleich des Vor-, Drain- und Mischkreises. Die Abstimmspannungen für die Kapazitätsdioden dieser drei Kreise können unabhängig voneinander um eine maximale Differenzspannung von $\pm\Delta U$ von der Oszillatorabstimmspannung variiert werden. Dabei erfolgt der Abgleich der einzelnen Kreise völlig getrennt voneinander in mehreren iterativen Schritten. Nach jedem Schritt kontrolliert die Abgleichvorrichtung 15 mit Hilfe eines PLLgesteuerten Signalgenerators 17 unter Ausnutzung der vom ihm erzeugten monofrequenten Markensignale für den Bild- und Tonträger die Durchlaßkurve des Tuners. Die in Bezug auf die Oszillatorabstimmspannung jeweils anliegenden Differenzspannungen werden in einem Speicher 18 der Abgleichvorrichtung 15 bis zum nächsten Schritt zwischengespeichert. Sobald die Durchlaßkurve eines Kanals optimiert ist, bleiben die entsprechenden digitalisierten Werte der einzelnen Differenzspannungen im Arbeitsspeicher 18 der Abgleichvorrichtung 15 gespeichert, bis für alle abzugleichenden Kanäle der Abgleichvorgang ausgeführt ist. Der geschilderte automatische Abgleichvorgang kann auch manuell über die Stellvorrichtung 19 durchgeführt werden. Hierbei erfolgt die iterative Ermittlung der zu speichernden Abgleichwerte vorzugsweise durch manuell betätigbare Potentiometer. Unabhängig davon, ob der Abgleich manuell oder automatisch erfolgt, werden nach Beendigung des gesamten Abgleichs die ermittelten Abgleichdaten für die einzelnen Kanäle mit entsprechenden Adressen in den nichtflüchtigen Speicher 11 des Tuners zur permanenten Abspeicherung übertragen. Zur Ausschließung von Fehlern beim Laden des nichtflüchtigen Speichers 11 erfolgt anschließend ein nochmaliger Vergleich der permanent abgespeicherten Abstimmdaten im Tuner mit den während des Abgleichs ermittelten Abstimmdaten im Arbeitsspeicher 18 der Abgleichvorrichtung 15.

Beim Einsatz eines derart fest abgestimmten Tuners in ein Fernsehgerät wird der Steuereingang und/oder -ausgang 12 mit dem dort ohnehin vorhandenen geräteinternen Mikrocomputer 13 verbunden. Der Mikrocomputer wählt dann bei Aufruf eines bestimmten Kanals über die damit gekoppelte Adresse die entsprechenden Abstimmdaten aus dem nichtflüchtigen Speicher 11 des Tuners aus. Diese werden dann über den Datenbus und den Digital-Analog-Converter 9 als analoge Abstimmspannungen den einzelnen Kapazitätsdioden zugeführt. Die Abstimmspannungen für die nicht abgespeicherten Frequenzkanäle ermittelt der Mikrocomputer 13 durch lineare Interpolation aus den für die benachbarten Kanäle permanent abgespeicherten Werten.

**Patentansprüche**

1. Verfahren zum Abgleich eines mit mehreren unabhängig voneinander ansteuerbaren Reaktanzelementen abstimmbaren mehrstufigen selektiven Verstärkers, insbesondere Tuners, dadurch gekennzeichnet, daß der selektive Verstärker (14), insbesondere Tuner, von einer externen Abgleichvorrichtung (15) mittels eines Mikrocomputers (16) zur Steuerung des gesamten Abgleichvorganges, eines mit einem Phasenregelkreis gesteuerten Signalgenerators (17) zur Erzeugung von automatischen Abgleichsignalen und eines Speichers (18) über die Reaktanzelemente (1 bis 8) abgeglichen wird, indem die zur Ansteuerung der einzelnen Reaktanzelemente (1 bis 8) benötigten Abgleichwerte in interativen Abgleichschritten ermittelt und jeweils im Speicher (18) zwischengespeichert werden, und daß nach Optimierung und Beendigung des Abgleichvorganges die endgültigen Abgleichwerte in einen nichtflüchtigen Speicher (11) des selektiven Verstärkers (14), insbesondere Tuners, übertragen und dort für dessen späteren Betriebszustand permanent gespeichert werden.

2. Verfahren nach Anspruch 1, dadurch gekennzeichnet, daß die einzelnen Stufen oder Kreise des selektiven Verstärkers (14) nacheinander und unabhängig voneinander abgeglichen werden.

3. Verfahren nach Anspruch 1 oder 2, dadurch gekennzeichnet, daß der selektive Verstärker (14) in jedem n-ten (n > 1) Frequenzkanal abgeglichen und die entsprechenden Abgleichwerte permanent im Verstärker abgespeichert werden.

4. Verfahren nach Anspruch 3, dadurch gekennzeichnet, daß n in Abhängigkeit des Kennlinienverlaufes der Reaktanzelemente (1 bis 8) in einem Bereich n ≥ 2 variiert wird.

5. Verfahren nach den Ansprüchen 3 oder 4, dadurch gekennzeichnet, daß die Abgleichwerte für die nicht abgespeicherten Frequenzkanäle im Betriebszustand des selektiven Verstärkers (14) durch lineare Interpolation aus den für die benachbarten Kanäle permanent abgespeicherten Werten ermittelt werden.

6. Verfahren nach einem oder mehreren der Ansprüche 1 bis 5, dadurch gekennzeichnet, daß als Abgleichwerte für die Reaktanzelemente (1 bis 3 und 5 bis 7) der Vor- und Zwischenkreise nur die Differenzwerte in Bezug auf den absoluten Abgleichwert für die Reaktanzelemente (4, 8) der Oszillatorkreise des selektiven Verstärkers (14) permanent abgespeichert werden.

7. Anordnung zur Durchführung des Verfahrens nach einem oder mehreren der Ansprüche 1 bis 6, zum Abgleich eines mit mehreren unabhängig voneinander ansteuerbaren Reaktanzelementen abstimmbaren mehrstufigen selektiven Verstärkers, insbesondere Tuners, dadurch gekennzeichnet, daß an den selektiven Verstärker (14), insbesondere Tuner, eine externe Abgleichvorrichtung (15) anschließbar ist, die einen Mikrocomputer (16) zur Steuerung des gesamten Abgleichvorganges, einen mittels Phasenregelkreis gesteuerten Signalgenerator (17) zur Erzeugung von automatischen Abgleichsignalen in Form von monofrequenten, den Informationsträgern der Durchlaßkurven des selektiven Verstärkers, insbesondere Tuners entsprechenden Markensignalen und einen Speicher (18) zur Zwischenspeicherung der in iterativen Abgleichschritten gewonnen Abgleichwerte für die einzelnen Reaktanzelemente (1 bis 8) enthält, und daß der selektive Verstärker (14), insbesondere Tuner, mit einem nichtflüchtigen Speicher (11) ausgestattet ist, in den die Abgleichvorrichtung (15) nach beendetem Abgleich aller Frequenzkanäle die optimierten Abgleichwerte überträgt, die dort für den späteren Betriebszustand des Verstärkers (14), insbesondere Tuners, permanent speicherbar sind.

8. Anordnung nach Anspruch 7, dadurch gekennzeichnet, daß die Abgleichvorrichtung (15) eine zusätzliche manuell betätigbare Stellvorrichtung (19) besitzt.

9. Anordnung nach Anspruch 8, dadurch gekennzeichnet, daß die Stellvorrichtung (19) in Form von mehreren Potentiometern ausgebildet ist.

10. Anordnung zur Durchführung des Verfahrens nach Anspruch 5, dadurch gekennzeichnet, daß im Betriebszustand des fest abgeglichenen selektiven Verstärkers (14) ein bereits vorhandener Mikrocomputer (13) anstelle der Abgleichvorrichtung (15) angeschlossen ist, der die lineare Interpolation zur Ermittlung der nicht abgespeicherten Abgleichwerte übernimmt.

**Revendications**

1. Procédé pour équilibrer un amplificateur sélectif à plusieurs étages, notamment un syntoniseur, pouvant être syntonisé à l'aide de plusieurs éléments de réactance commandables indépendamment les uns des autres, caractérisé en ce que l'amplificateur sélectif (14), notamment le synthoniseur, est équilibré par un dispositif extérieur d'équilibrage (15) à l'aide d'un micro-ordinateur (16) servant à commander l'ensemble de l'opération d'équilibrage, d'un générateur de signaux (17) commandé par un circuit de régulation de phase et servant à produire des signaux d'équilibrage automatique, et d'une mémoire (18), par l'intermédiaire des éléments de réactance (1 à 8), par le fait que les valeurs d'équilibrage nécessaires pour la commande de différents éléments de réactance (1 à 8) sont déterminées selon des pas itératifs d'équilibrage et sont respectivement mémorisées temporairement dans la mémoire (18), et qu'après l'optimisation et la fin de l'opération d'équilibrage, les valeurs d'équilibrage définitives sont transmises dans une mémoire non volatile (11) de l'amplificateur sélectif (14), notamment du syntoniseur, et sont mémorisées en permanence dans cette mémoire, pour l'état de fonctionnement ultérieur de cet amplificateur.

2. Procédé selon la revendication 1, caractérisé en ce que les différents étages ou circuit de l'amplificateur sélectif (14) sont équilibrés successivement et indépendamment les uns des autres.

3. Procédé selon la revendication 1 ou 2, caractérisé en ce que l'amplificateur sélectif (14) situé dans chaque n-ème (n > 1) canal de fréquence est équilibré et que les valeurs correspondantes d'équilibrage sont mémorisées de façon permanente dans l'amplificateur.

4. Procédé selon la revendication 3, caractérisé en ce que n est modifié en fonction de la variation de la courbe caractéristique des éléments de réactance (1 à 8) dans une gamme n ≥ 2.

5. Procédé selon les revendications 3 et 4, caractérisé en ce que les valeurs d'équilibrage pour les canaux de fréquences non mémorisés dans l'état de fonctionnement de l'amplificateur sélectif (14) sont déterminés par interpolation linéaire à partir des valeurs mémorisées de façon permanente pour les canaux voisins.

6. Procédé selon une ou plusieurs des revendications 1 à 5, caractérisé en ce que, en tant que valeurs d'équilibrage pour les éléments de réactance (1 à 3 et 5 à 7) des circuits amont et des circuits intermédiaires, seules les valeurs de différences en rapport avec la valeur d'équilibrage absolue pour les éléments de réactance (4, 8) du circuit oscillateur de l'amplificateur sélectif (14) sont mémorisées de façon permanente.

7. Dispositif pour la mise en oeuvre du procédé selon une ou plusieurs des revendications 1 à 6 pour l'équilibrage d'un amplificateur sélectif à plusieurs étages, notamment un syntoniseur, pouvant être accordé à l'aide de plusieurs éléments de réactance pouvant être commandés indépendamment les uns des autres, caractérisé par le fait qu'à l'amplificateur sélectif (14), notamment au syntoniseur, peut être raccordé un dispositif extérieur d'équilibrage (15), qui contient un micro-ordinateur (16) servant à commander l'ensemble de l'operation d'équilibrage, un générateur de signaux (17) commandé au moyen d'un circuit de régulation de phase et servant à produire des signaux d'équilibrage automatique sous la forme de signaux de marquage à une fréquence, correspondant aux porteuses d'informations de la courbe de transmission de l'amplificateur sélectif, notamment du syntoniseur, une mémoire (18) pour la mémorisation intermédiaire des valeurs d'équilibrage, obtenue selon des pas d'équilibrage itératifs, pour les éléments individuels de réactance (1 à 8), et que l'amplificateur sélectif (14), notamment le syntoniseur, est équipé d'une mémoire non volatile (11), dans laquelle le dispositif d'équilibrage (15) transmet, à la fin de l'équilibrage de tous les canaux de fréquences, les valeurs d'équilibrage optimisées, qui peuvent être mémorisées de façon permanente dans cette mémoire pour l'état de fonctionnement ultérieur de l'amplificateur (14), notamment du syntoniseur.

8. Dispositif selon la revendication 7, caractérisé en ce que le dispositif d'équilibrage (15) possède un dispositif supplémentaire de réglage (19), pouvant être actionné manuellement.

9. Dispositif selon la revendication 8, caractérisé en ce que le dispositif de réglage (19) est constitué sous la forme de plusieurs potentiomètres.

10. Dispositif pour la mise en oeuvre du procédé selon la revendication 5, caractérisé en ce que, pendant le fonctionnement de l'amplificateur (14) sélectif équilibré de manière fixe, à la place du dispositif d'équilibrage (15), on branche un microordinateur (13) déjà disponible qui réalise l'interpolation linéaire en vue de la détermination des valeurs d'équilibrage non mises en mémoire.

## Claims

1. Method for calibrating a multi-stage selective amplifier which can be tuned by means of several reactance elements which can be driven independently of one another, particularly a tuner, characterized in that the selective amplifier (14), particularly the tuner, is calibrated by an external calibration device (15) by means of a microcomputer (16) for controlling the entire calibration process, a signal generator (17) controlled by means of a phase-locked loop, for generating automatic calibration signals, and a store (18) via the reactance elements (1 to 8) in that the calibration values needed for driving the individual reactance elements (1 to 8) are determined in iterative calibration steps and are in each case temporarily stored in the store (18) and in that after optimization and termination of the calibration process, the final calibration values are transferred into a non-volatile store (11) of the selective amplifier (14), particular of the tuner, where they are permanently stored for its later operating state.

2. Method according to Claim 1, characterized in that the individual stages or circuits of the selective amplifier (14) are calibrated successively and independently of one another.

3. Method according to Claim 1 or 2, characterized in that the selective amplifier (14) is calibrated in each nth (n > 1) frequency channel and the corresponding calibration values are permanently stored in the amplifier.

4. Method according to Claim 3, characterized in that n is varied in dependence of the characteristic curve of the reactance elements (1 to 8) in a range n ≥ 2.

5. Method according to Claims 3 or 4, characterized in that the calibration values for the frequency channels not stored are determined in the operating state of the selective amplifier (14) by linear interpolation of the values permanently stored for the adjacent channels.

6. Method according to one or more of Claims 1 to 5, characterized in that only the difference values with respect to the absolute calibration value for the reactance elements (4, 8) of the oscillator circuits of the selective amplifier (14) are permanently stored as calibration values for the reactance elements (1 to 3 and 5 to 7) of the RF and IF circuits.

7. Arrangement for carrying out the method according to one or more of Claims 1 to 6, for calibrating a multistage selective amplifier which can be tuned by means of several reactance elements which can be driven independently of one another, particularly a tuner, characterized in that the selective amplifier (14), particularly the tuner, can be connected to an external calibration device (15) which contains a microcomputer (16) for controlling the entire calibration process, a signal generator (17), controlled by means of a phase-locked loop, for generating automatic calibration signals in the form of mono-frequency marker signals corresponding to the information carriers of the pass curves of the selective amplifier, particularly the tuner, and a store (18) for temporarily storing the calibration values obtained in iterative calibration steps for the individual reactance elements (1 to 8), and in that the selective amplifier (14), particularly the tuner, is equipped with a non-volatile store (11) into which the calibration device (15), after completed calibration of all frequency channels, transfers the optimized calibration values which can be permanently stored there for the later operating stage of the amplifier (14), particularly the tuner.

8. Arrangement according to Claim 7, characterized in that the calibration device (15) has an additional adjusting device (19) which can be manually operated.

9. Arrangement according to Claim 8, characterized in that the adjusting device (19) is constructed in the form of several potentiometers.

10. Arrangement for carrying out the method according to Claim 5, characterized in that in the operating state of the completely calibrated selective amplifier (14), an already existing microcomputer (13) is connected instead of the calibration device (15), which takes over the linear interpolation for determination of the calibration values not stored.